Europäisches Patentamt

European Patent Office

Office européen des brevets

(11) Numéro de publication : **0 387 113 B1**

## (12) FASCICULE DE BREVET EUROPEEN

(45) Date de publication du fascicule du brevet :
**22.12.93 Bulletin 93/51**

(51) Int. Cl.⁵ : **C23C 16/02,** C23C 28/04,
C23C 16/30

(21) Numéro de dépôt : **90400374.6**

(22) Date de dépôt : **12.02.90**

(54) **Procédé de dépôt d'un revêtement de type céramique sur un substrat métallique et élément comportant un revêtement obtenu par ce procédé.**

(30) Priorité : **16.02.89 FR 8902048**

(43) Date de publication de la demande :
**12.09.90 Bulletin 90/37**

(45) Mention de la délivrance du brevet :
**22.12.93 Bulletin 93/51**

(84) Etats contractants désignés :
**AT BE CH DE DK ES FR GB GR IT LI LU NL SE**

(56) Documents cités :
**EP-A- 0 013 644
CH-B- 405 872
DE-A- 1 446 272
US-A- 3 474 017
CHEMICAL ABSTRACTS, vol. 89, no. 22,
novembre 1978, page 252, résumé no.
184069w, Columbus, Ohio, US
PLATING, vol. 53, no. 6, juin 1966, pages
772-782, American Electroplates Society,
Newark, NY, US; J.E. KNAP et al.: "Vapor
plating with dicumenechromium preparation
and properties of the chromium plate"**

(73) Titulaire : **NITRUVID
9, Rue Jean Poulmarch Zone Industrielle
Duval
F-95100 Argenteuil (FR)**
Titulaire : **FORTECH
La Défense 9 - 4, Place de la Pyramide
F-92800 PUTEAUX (FR)**

(72) Inventeur : **Nowak, Jean-François,
33, Place Fourneyron,
F-42000 Saint Etienne (FR)**
Inventeur : **Maury, Francis,
13, rue Bernard Dard,
F-31320 Labege (FR)**
Inventeur : **Oquab, Djarollah,
E.N.S.C.T, 118, Route de Narbonne,
F-31077 Toulouse Cedex (FR)**
Inventeur : **Morancho, Roland,
69, rue Pierre Cazeneuve,
F-31200 Toulouse, (FR)**

(74) Mandataire : **Le Guen, Gérard et al
CABINET LAVOIX 2, place d'Estienne d'Orves
F-75441 Paris Cédex 09 (FR)**

## Description

La présente invention concerne un procédé de dépôt d'un revêtement du type céramique à base de carbures, nitrures, ou carbonitrures d'éléments métalliques tels que Cr,V,Zr,W,Mo,Co,Mn,Ni,Hf,Ta,Ti,Nb et Fe dans lequel on dépose le revêtement du type céramique à basse température en phase vapeur à partir de précurseurs organo-métalliques sur un substrat métallique.

Dans FR-2 439 824, on a déjà décrit un procédé de chromisation par voie gazeuse d'un acier comprenant trois traitements successifs, à savoir une nitruration ionique dans un mélange d'azote et d'hydrogène à une température de 450 à 550°C, une chromisation par voie gazeuse à partir d'un mélange de ferro-chrome et de chlorure d'ammonium à une température de 850 à 1100°C et un traitement thermique comprenant une trempe à l'huile et un revenu d'une température de 600 à 650°C.

Dans ce procédé, les traitements successifs sont effectués dans des installations distinctes.

De plus dans ce procédé la couche de nitruration sert exclusivement de réserve d'azote qui rétrodiffuse vers la surface lors de l'opération de dépôt de chromisation à haute température pour participer à la formation de carbonitrures.

En raison de la rétrodiffusion d'azote, les propriétés mécaniques de la couche nitrurée (augmentation de dureté, présence de contraintes résiduelles de compression) sont détruites.

Les dépôts obtenus par chromisation (dans un système Cr(C,N)) sont très adhérents sur le substrat en raison de la diffusion des éléments du substrat dans le revêtement avec déplacement de l'interface. Par contre ils induisent du fait des hautes température de traitement des variations dimensionnelles qui peuvent être rédhibitoires pour les pièces revêtues.

En outre ce procédé nécessite la mise en oeuvre d'un traitement thermique ultérieur pour régénérer les propriétés mécaniques à coeur du substrat.

Le dépôt de chrome à basse température (OMCVD) sur des substrats tels que silicium est par ailleurs bien connu et notamment décrit par N.G. ANANTHA, V.Y. DOO et D.K. SETO dans J. Electrochem. Soc., Vol. 118, n° 1 (1975), 163 à l'aide d'un précurseur dicumène chrome (DCC).

Le dépôt de carbure de chrome sur des aciers est également connu par la publication J. E. KNAP, B. PETRETSKY et F.N. HILL, Plating, 53 (1966), 772.

L'adhérence des dépôts ainsi obtenus à basse température est moindre que celle du procédé précédemment décrit (difficulté de préparation de surface) dont les inconvénients au niveau conservation des qualités dimensionnelles ont déjà été mentionnées.

La présente invention permet de réaliser des revêtements tels que des revêtements de carbures, nitrures et carbonitrures d'éléments métalliques dans une même installation.

La présente invention a ainsi pour objet un procédé de dépôt d'un revêtement du type céramique à base de carbures, nitrures, ou carbonitrures d'éléments métalliques choisi parmi Cr,V,Zr,W,Mo,Co,Mn,Ni,Hf, Ta,Ti,Nb et Fe dans lequel on dépose le revêtement du type céramique à basse température en phase vapeur à partir de précurseurs organo-métalliques sur un substrat métallique, caractérisé en ce qu'on réalise préalablement à ce dépôt en phase vapeur et sans mise en contact avec une atmosphère oxydante et/ou polluante ultérieure, un décapage ionique réactif en atmosphère réductrice.

Le décapage ionique réactif est notamment une nitruration ionique. Cette nitruration ionique peut être réalisée sous un mélange N2,H2 dont la teneur en azote est inférieure à 25% en volume, à une température du substrat de 400 à 600°C, sous une pression inférieure ou égale à 1kPa et de préférence inférieure à 0,5kPa pour atteindre une épaisseur de couche de diffusion d'azote de 10 à 500 $\mu$m selon la nature du substrat.

Le dépôt ultérieur en phase vapeur peut être réalisé, sur le substrat préalablement chauffé à une température de 300 à 700°C en présence d'un flux de gaz vecteur généralement inerte tel que Ar,He, contenant au moins un précurseur organo-métallique sous une pression totale inférieure à 10kPa et de préférence inférieure à 5kPa.

On peut notamment réaliser un revêtement de carbure de chrome de formule $Cr_7C_3$ en phase vapeur à partir de bis arènes chrome éventuellement substitués et notamment de bis cumène chrome ou de dibenzène chrome comme précurseurs.

On peut en outre réaliser un revêtement de nitrures de titane de formule TiN en phase vapeur à partir de précurseur du type amine notamment tétrakis(dialkylamine)titane de formule $Ti(NR_2)_4$ où R est un groupe alkyle en $C_1$-$C_4$, de carbonitrures de titane de formule $Ti\,N_x\,C$ à partir de précurseur de type bipyridine.

De même on peut réaliser un revêtement de nitrure de zirconium de formule ZrN en phase vapeur à partir de précurseur de type amine notamment de tétrakis(dialkylamine)zirconium de formule $Zr(NR_2)_4$ où R est un groupe alkyle en $C_1$-$C_4$.

On peut également réaliser un revêtement de nitrures ou carbonitrures d'éléments métalliques tels que Cr,V,Zr,W,Mo,Co,Mn,Ni,Hf,Ta,Ti,Nb et Fe à partir d'un système de précurseurs constitué simultanément par un précurseur organo-métallique de type sandwich et un précruseur d'azote.

Le précruseur organo-métallique est choisi parmi les composés organo-métallique de type sandwich de formule générale

$$[Ar^1 M Ar^2_n] L_x L'_y$$

dans laquelle $Ar^1$ et $Ar^2$ identiques ou différents représentent un cycle aromatique en $C_5$-$C_8$ éventuellement substitué par 1 à 6 groupes alkyle en $C_1$-$C_4$ ou un groupe phényle, n représente 0 ou 1 , M représente l'élément métallique tel que défini ci-dessus, L et L' représentent isolément un atome d'hydrogène ou d'halogène, un groupe CO, NCO, NCS, $CF_3$, R, RCN , $PR_3$, SR, SeR, R étant un groupe alkyle en $C_1$-$C_4$ phényle éventuellement substitué par 1 ou 2 groupes alkyle en $C_1$-$C_4$, pyridine, tétrahydrofuranne, acétylacétonate, tétracyanoquinodiméthane ou L et L' représentent ensemble avec M un cycle $MS_4$ ou $MS_5$ et x + y représentent de 0 à 4.

Un premier groupe de composés de type sandwich utilisés, sont ceux où l'élément métallique (M) est lié au moyen de liaisons du type $\pi$ coordinées à deux cycles aromatiques. Dans le cas où M est lié à deux cycles, M est situé entre les plans formés par les deux cycles.

Dans ce groupe de composés le métal est à l'état zéro valent.

Comme exemples de tels composés, on peut citer les complexes du :

- chrome : $Cr(C_5H_5)_2$, $Cr(C_6H_6)_2$,
- vanadium : $V(C_5H_5)_2$, $V(C_6H_6)_2$, $V(C_5H_5) (C_7H_7)$,
- tungstène : $W(C_6H_6)_2$,
- molybdène : $Mo(C_6H_6)_2$,
- cobalt : $Co(C_5H_5)_2$,
- manganèse : $Mn[C_5H_4(CH_3)_2]$, $[Mn(C_5H_5)_2]_n$ (qui est un composé polymère),
- nickel : $Ni(C_5H_5)_2$, $Ni[C_8H_7(C_6H_5)]_2$, (cycle aromatique à 8 atomes de carbone substitué par un groupe phényle),
- titane : $Ti(C_5H_5) (C_7H_7)$, $Ti(C_5H_5)(C_8H_8)$,
- fer : $Fe(C_5H_5)_2$, $Fe[C_5(CH_3)_5]_2$.

Un second groupe est constitué par les composés dans lesquels l'élément métallique (M) est lié d'une part à un cycle ou deux cycles aromatiques ($Ar^1$ et $Ar^2$) au moyen de liaisons $\pi$ coordinées, et d'autre part à des ligands L et L', au moyen de liaisons qui peuvent être covalentes ou de coordination. Le nombre de ligands L et L' est fonction de la nature du ligand et de la nature du métal.

Comme exemples de composés dans lesquels les ligands L et L' sont liés au moyen de liaisons covalentes, on trouve :

- pour le vanadium : $V(C_5H_5)_2Cl$, $V(C_5H_5)_2 (C_6H_5S)_2$, $V[C_5H_4(CH_3)]_2Cl_2$,
- le zirconium : $Zr(C_5H_5)_2Cl_2$, $Zr(C_8H_8)Cl_2$,
- l'hafnium : $Hf(C_5H_5)_2(CH_3)_2$,
- le tantale : $Ta(C_5H_5)_2H_3$,
- le tungstène : $W(C_5H_5)_2S_4$ (dans lequel l'élément métallique forme un cycle à 5 chaînons avec les 4 atomes de soufre),
- le molybdène : $Mo (C_5H_5)Cl_2$.
- le titane: $Ti(C_5H_5)_2Cl_2$, $Ti(C_5H_5)_2(C_6H_5)_2$, $Ti(C_5H_5)_2S_5$ (dans lequel le Ti forme un cycle à 6 chaînons avec 5 atomes de soufre), $Ti[C_5(CH_3)_5]_2Cl_2$, $Ti(C_5H_5)Br_3$, $Ti(C_5H_5)Cl_3$,
- le niobium : $Nb(C_5H_5)_2Cl_2$, $Nb(C_5H_5)H_3$, $Nb (C_6H_6)_2(CH_3)_2$.

Des exemples de composés dans lesquels un ou les ligands L et L' sont liés au moyen de liaisons de coordination sont :

- pour le vanadium : $V(C_5H_5)(CO)_4$, $V(C_6H_6) (CH_3CN)_3$, $V(C_7H_7)CO$,
- le zirconium $Zr(C_5H_5)_2(CO)_2$, $Zr(C_5H_5) (C_5H_7O_2)_2Cl$ ($C_5H_7O_2$ = acétylacétate), $Zr(C_8H_8)_2$ THF (THF = tétrahydrofuranne),
- l'hafnium : $Hf(C_5H_5)_2(CO)_2$,
- le tungstène : $W(C_5H_5)(C_6H_5)(CO)_3$, $W(C_7H_7)(C_6H_5Se)(CO)_2$,
- le molybdène : $Mo(C_5H_5)_2(CO)_3$,
- le cobalt : $CO[C_5(CH_3)_5](CO)_2$,
- le manganèse : $Mn(C_6H_6)(CH_3CN)_3$,
- le nickel : $Ni (C_5H_5)(CF_3)P(C_6H_5)_3$.
- le titane : $Ti(C_5H_5)_2(NCO)_2$, $Ti(C_5H_5)_2 (NCS)_2$,
- le fer : $Fe(C_5H_5)(CH_3CH_2S)(CO)$, $Fe(C_8H_8) (CO)_3$.

On préfère les précurseurs organo-métalliques dans lesquels l'élément métallique central est lié à deux cycles aromatiques identiques en $C_5$-$C_8$ éventuellement substitués par un à 6 groupes alkyle en $C_1$-$C_4$.

Le précurseur d'azote est l'ammoniac ou l'hydrazine.

Le dépôt est réalisé par décomposition chimique en phase vapeur sous une pression inférieure à 10kPa dans une plage de température comprise entre 300 et 600°C.

La présente invention a également pour objet un élément tubulaire ou plan constitué d'un substrat métallique comportant au moins sur une de ces faces un revêtement du type céramique à base de carbures, nitrures ou carbonitrures d'éléments métalliques tels que Cr,V, Zr,W,Mo,Co,Mn,Ni,Hf,Ta,Ti,Nb et Fe déposé en une épaisseur de 5 à 200 µm sur une couche de diffusion d'azote ayant une épaisseur de 20 à 500 µm, réalisés par un procédé tel que défini ci-dessus. Le substrat métallique peut être notamment un acier de construction pour usage mécanique, un acier inoxydable, un alliage de zirconium ou un alliage de titane.

On décrira ci-après le procédé selon l'invention ainsi qu'une installation pour sa mise en oeuvre dans le cas d'un traitement comprenant successivement une nitruration ionique puis un revêtement de carbure de chrome $Cr_7C_3$ obtenu à partir de bis cumène chrome sur la surface de pièces tubulaires. Cette description est faite en se référant aux dessins annexés sur lesquels :

- la Fig.1 représente un schéma d'ensemble de l'installation utilisée pour réaliser le traitement selon l'invention; et
- la Fig.2 représente à plus grande échelle une coupe verticale de la pièce tubulaire à nitrurer et à revêtir de carbure de chrome successivement, son anode d'amenée de gaz et le dispositif de suspension de ceux-ci.

On décrira successivement un mode de réalisation de l'installation et du dispositif d'amenée des gaz, puis l'application, au moyen de cette installation et dudit dispositif, de chacune des deux séquences constituant le traitement de surface défini précédemment.

Description de l'installation.

L'installation se compose principalement :
- d'un réacteur métallique de type mécanosoudé 1, constitué lui-même par une enceinte cylindrique à double paroi 2 munie d'écrans protecteurs contre les radiations 3 et de passages étanches et isolés électriquement 4 pour l'alimentation électrique en basse tension des éléments chauffants en tôle déployée inoxydable 5, une platine supérieure avec système de refroidissement par eau incorporé 6 et munie d'une part d'un passage de courant 7 pour la mise sous haute tension électrique de la pièce à traiter 8, et, d'autre part, d'un nombre suffisant de piquages tubulaires pour la fixation des divers systèmes de contrôle ou de mesure des paramètres du procédé de dépôt (p, T, etc...) ainsi que pour l'entrée des gaz vecteurs ou réactif, une platine inférieure 9 reliée au système à vide de l'installation.
- d'un système à vide 11, lui-même constitué d'une pompe primaire à deux étages 12, d'une pompe à diffusion d'huile 13, d'un piège à azote liquide 14, d'un ensemble de vannes pour le réglage de la pression de travail 15.
- d'une unité d'énergie électrique 16 qui délivre une tension continue réglable entre 0 et 950 volts et un courant continu compris entre 0 et 360 ampères, la puissance de branchement étant de 420 KVA.

L'unité d'énergie électrique assure donc l'alimentation en courant continu du réacteur. Elle comprend un dispositif redresseur en pont du courant continu ou alternatif avec commutation forcée. La régulation de température permet de maintenir un courant constant et cela par l'intermédiaire d'un redresseur automatique, la commutation forcée conduisant à une interruption rapide du courant en cas d'irrégularité dans le régime de décharge électrique luminescente.

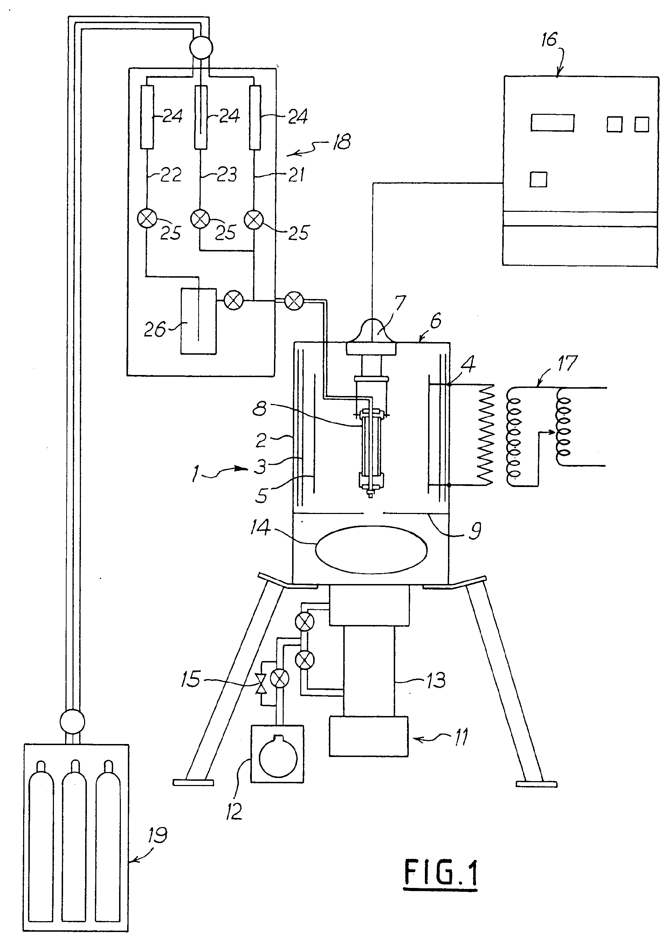

A cette unité d'énergie est associée une console de contrôle qui comprend principalement les dispositifs de régulation, les systèmes de sécurité et d'arrêt automatiques ainsi que les enregistreurs.
- Une alimentation électrique basse tension 17 en triphasé avec adaptation de la tension par transformateur, la tension secondaire entre phases étant de 28 volts. Le contrôle de la puissance délivrée s'effectue par groupe à thyristor à commande en angle de phase avec protection RC pour charge selfique.
- D'un système d'alimentation 18 en précurseur bis (cumène) chrome (DCC) comprenant principalement une centrale d'alimentation de gaz basse pression ($10^5$ Pa) 19, trois lignes d'alimentation de gaz, respectivement repérées 21, 22 et 23 sur la Fig.1, en acier inoxydable, qui sont équipées chacune d'un débimètre massique 24 et de vannes étuvables jusqu'à 150°C, 25. La ligne 21 a pour fonction principale d'alimenter le réacteur en mélange gazeux N2-H2 pendant la première séquence de décapage ionique réactif, elle peut être également utilisée comme ligne de dilution pendant la seconde séquence de dépôt de carbure de chrome. La ligne 22 est utilisée pour entraîner le précurseur DCC jusqu'à l'enceinte réactionnelle, grâce au barbotage d'un gaz vecteur, généralement un gaz inerte, dans un flacon laveur 26 thermorégulé à la température choisie, et dans lequel a été initialement introduit le précurseur. La ligne 23 permet de diluer le mélange gazeux réactif transporté par la ligne 21 soit par un gaz inerte, soit par un gaz réactif.

Description de l'anode centrale d'amenée de gaz.

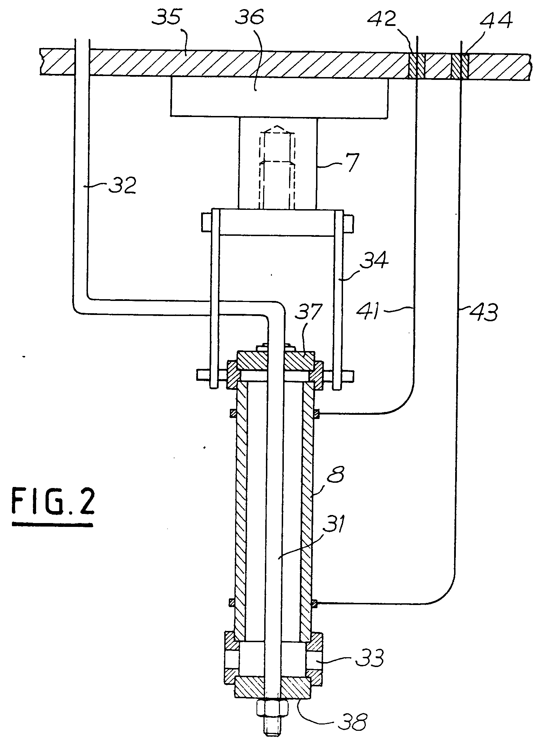

Pour réaliser la première séquence de décapage ionique réactif, on utilise une anode centrale telle que celle décrite dans FR-A-2 446 326 qui est représentée plus en détail sur la Fig.2.

Cette anode centrale 31, de type tubulaire, permet d' amener le mélange gazeux réactif H2 + N2 à l'intérieur de la pièce tubulaire 8. La distance entre l'anode centrale 31 et la surface interne de la pièce tubulaire 8 est constante d'une extrémité à l'autre de la pièce tubulaire et toujours comprise entre 3 et 9 millimètres, de préférence entre 6 et 8 millimètres. Le conduit d'arrivée du mélange gazeux réactif à l'intérieur de la pièce tubulaire est représenté en 32. Sa distribution est assurée au moyen d'orifices calibrés disposés en quinconce et dont le diamètre varie d'une extrémité à l'autre de la pièce tubulaire, depuis 1 millimètre à l'entrée jusqu'à 2,5 millimètres à la sortie. Les orifices supplémentairs d'évacuation du mélange gazeux, représentés en 33, sont à une distance de l'extrémité de l'élément tubulaire de 20 à 50 mm, ils sont au nombre de 3, disposés à 120° sur une même section transversale de l'anode et leur diamètre est de 4 millimètres. L'élément tubulaire 8 avec son anode centrale 31 est suspendu, par l'intermédiaire d'un étrier métallique 34 au passage de courant 7 lui-même fixé à la platine supérieure de l'enceinte réactionnelle 35. Le passage de courant 7 est isolé électriquement de la platine supérieure au moyen de la pièce céramique représentée en 36. L'anode centrale 31 amenant le mélange gazeux réactif est centrée sur l'élément tubulaire 8 et isolé de ce dernier au moyen de deux pièces de céramiques 37 et 38. Les deux thermocouples qui assurent le réglage optimal des paramètres électriques, de la pression régnant dans l'enceinte réactionnelle et de l'écoulement gazeux, sont représentés, avec leur dispositif de guidage et d'isolation au travers de la platine supérieure 35, en 41 et 42 pour le thermocouple de régulation et 43 et 44 pour le thermocouple de contrôle.

Le dispositif de suspension de l'élément tubulaire et d'amenée des gaz à l'intérieur dudit élément tubulaire, précédemment décrit, est également utilisé pour réaliser la seconde séquence du traitement. Cependant, pour cette séquence de dépôt de carbure de chrome, on peut éventuellement utiliser un dispositif permettant la remontée de l'anode centrale en dehors de l'élément tubulaire et l'alimentation en précurseur par la partie supérieure de l'alésage dudit élément tubulaire.

Description de la première séquence du traitement.

La première séquence du traitement qui est une séquence de décapage ionique réactif, s'effectue par décharge électrique au sein d'un mélange gazeux hydrogène-azote maintenu à pression réduite, et dans un domaine de tension qui correspond au régime de décharge luminescente anormale, caractérisé par une augmentation de la tension électrique, avec la densité de courant. Dans ces conditions de décharge électrique, créées par l'application entre les pièces tubulaires fonctionnant comme une cathode et l'anode centrale d'une différence de potentiel électrique comprise entre 300 et 600 volts, l'effluve électrique recouvre de façon homogène toute la surface des pièces à traiter.Les ions gazeux formés dans la décharge électrique sont accélérés dans le champ intense qui règne au voisinage immédiat de la cathode, l'essentiel de la chute de tension se produisant dans un espace enveloppant la cathode sur une épaisseur voisine du dixième de millimètre à quelques millimètres suivant les conditions opératoires (pression, nature du gaz et du métal composant les électrodes) et viennent bombarder la surface des pièces provoquant ainsi son échauffement jusqu'à des températures correspondant à l'émission thermo-électronique. Par ailleurs, ces ions incidents s'implantent à la surface des pièces sur quelques distances interatomiques provoquant un enrichissement en constituants qui diffusent ensuite dans les pièces sous l'effet de la température.

Cette première séquence de décapage ionique réactif utilise en permanence un mélange gazeux composé d'hydrogène et d'azote, dont la teneur en azote est avantageusement inférieure à 25% en volume. Elle comprend cinq phases distinctes successives, dans l'ordre suivant :

a) une mise sous vide de l'enceinte réactionnelle contenant les pièces tubulaires et leur anode jusqu'à l'obtention d'une pression résiduelle inférieure à $10^{-2}$ Pa.

b) immédiatement après arrêt de la pompe secondaire, introduction dans l'enceinte réactionnelle du mélange hydrogène-azote jusqu'à obtention d'une pression voisine de 400 Pa. Cet ajustement du niveau de pression dans l'enceinte réactionnelle est obtenu au moyen d'un réglage de la puissance de pompage du système à vide, opérant par étranglement de la canalisation d'aspiration. La régulation de la pression dans l'enceinte à la valeur souhaitée est fonction du débit de mélange gazeux.

c) un décapage de la surface des pièces par bombardement ionique sous pression réduite, inférieure à 80 Pa, avec une légère montée en température inférieure à 100°C.

d) une montée en température jusqu'à un maximum, accompagnée d'une augmentation progressive de la pression jusqu'à atteindre la pression de traitement, comprise entre 0,25 et 1 kPa. La montée en température est assurée par un ajustement de la tension électrique appliquée aux pièces tubulaires à traiter, le niveau de cette tension variant avec la pression régnant dans l'enceinte réactionnelle.

e) un maintien à la température constante maximale, sous ladite pression de traitement.

Au cours de cette première séquence de traitement dont la durée reste inférieure à 50 heures, la température constante maximale de la phase (e) est comprise entre 400 et 600°C.

Description de la seconde séquence du traitement.

La seconde séquence du traitement objet de la présente invention est destinée à réaliser un dépôt de carbure de chrome à la surface des pièces tubulaires, lesdites pièces ayant préalablement subi au cours de la première séquence du traitement un durcissement superficiel par diffusion de l'élément azote et/ou une modification de sa réactivité chimique de surface. Le dépôt de carbure de chrome est obtenu par décomposition thermique du précurseur bis(cumène) chrome mis en contact des pièces tubulaires, préalablement chauffées entre 300 et 700°C.

Cette seconde séquence de dépôt comprend les trois phases distinctes successives, dans l'ordre suivant :

a) phase de transition pendant laquelle sont effectuées successivement les opérations décrites ci-dessous :

- mise en fonctionnement du chauffage par résistor.
- substitution du mélange gazeux réactif H2 + N2 par un gaz inerte, tel que Ar, He, etc..., dans l'enceinte réactionnelle.
- suppression du plasma électrique par mise en arrêt du générateur haute tension.
- ajustement progressif de la pression dans l'enceinte réactionnelle à la valeur de traitement, choisie inférieure à 10 kPa.
- ajustement progressif de la température des pièces tubulaires à la valeur de traitement, comprise entre 300 et 700°C.

b) Introduction du précurseur bis(cumène) chrome dans l'enceinte réactionnelle par fermeture de la ligne d'alimentation 23 et simultanément ouverture de la ligne d'alimentation 22, et maintien à température constante de la pièce, sous ladite pression de traitement.

c) Un refroidissement final sous gaz inerte (fermeture ligne d'alimentation 22 et ouverture ligne d'alimentation 23).

Dans le cas du procédé de depot de nitrures ou carbonitrures utilisant le système de précurseurs constitués par le précurseur organo-métallique et le précurseur d'azote, le mode opératoire est identique excepté que les deux précurseurs sont amenés simultanément dans l'enceinte réactionnelle au moyen de deux lignes d'alimentation.

Le réglage du rapport des pressions partielles précurseur d'azote/précurseur organo-métallique permet d'obtenir un revêtement plus ou moins riche en cabone ou en azote allant des carbonitrures aux nitrures.

On donnera ci-après à titre non limitatif un exemple de réalisation d'un tel traitement séquencé, décapage ionique réactif suivi d'un dépôt de carbure de chrome par décomposition thermique du composé organométallique bis(cumène)chrome, à l'intérieur d'un élément tubulaire dans une installation et au moyen d'un dispositif comme ceux décrits précédemment, lorsque cet élément tubulaire est en acier du type 32 CDV 13.

Dans la première séquence du traitement, l'atmosphère réactive utilisée est un mélange gazeux azote-hydrogène contenant 2% en volume d'azote. L'opération comprend cinq phases distinctes :

- une mise sous vide de l'enceinte réactionnelle contenant les éléments tubulaires et leur anode, jusqu'à un niveau de pression résiduelle inférieur à $10^{-3}$ Pa
- une introduction dans l'enceinte d'un mélange azote-hydrogène contenant 2% en volume d'azote
- un décapage sous pression réduite, inférieure à 80 Pa, de mélange azote-hydrogène à 2% en volume d'azote, accompagné d'une légère montée en température, inférieure à 100°C en un temps voisin de 2 heures
- une montée en température, accompagnée d'une montée progressive en pression, jusqu'à atteindre la pression de traitement égale à 400 Pa, cette montée en température étant effectuée dans une durée voisine de 3 heures
- un maintien en température entre 480 et 485°C pendant une durée voisine respectivement de 1 heure si on veut exclusivement une modification de la réactivité chimique de la surface de l'élément tubulaire de longueur minimale 150 mm, et de 40 heures si en plus on veut réaliser un durcissement superficiel du substrat par un phénomène de diffusion à l'état solide de l'élément azote (création d'une couche de diffusion d'azote sans sous-couche superficielle de combinaison).

Dans la seconde séquence du traitement on réalise un dépôt de carbure de chrome $Cr_7 C_3$ d'une épaisseur voisine de 10 µm sur l'élément tubulaire dont la réactivité chimique de surface a été préalablement modifiée et dont le substrat métallique a été préalablement durci par le phénomène de diffusion à l'état solide de l'élément azote mis en jeu dans la première séquence du traitement. Cette seconde séquence du traitement s'effectue selon les quatre phases successives suivantes :

- une phase de transition pendant laquelle on réalise successivement les opérations suivantes : 1°) Mise en fonctionnement du chauffage par rayonnement (éléments 5). 2°) Substitution du mélange gazeux réactif d'hydrogène-azote à 2% d'azote par le gaz inerte helium (fermeture ligne d alimentation 21 et ouverture ligne d'alimentation 23). 3°) Suppression du plasma électrique (arrêt générateur H.T. 16) - 4°) Ajustement de la pression dans l'enceinte réactionnelle à 270 Pa (réglage du débit de pompage à l'aide de la vanne 15) et simultanément ajustement progressif de la température de la pièce tubulaire à 510/515°C
- Entraînement dans l'enceinte de dépôt, par fermeture de la ligne d'alimentation 23 et simultanément ouverture de la ligne d'alimentation 22, du précurseur bis(cumène)chrome par barbotage de gaz hélium dans un saturateur contenant ledit précurseur et préalablement chauffé à 110/120°C (à l'aide d'un bain d'huile thermostaté) et mise en contact de ce précurseur avec la surface interne de l'élément tubulaire préalablement mis en équilibre thermique à la température de 510/515°C.
- Maintien d'une durée de deux à trois heures à une température constante égale à 510/515°C de l'élément tubulaire, sous une pression constante de 270 Pa de mélange réactif hélium-bis(cumène)chrome.
- Refroidissement final sous hélium (fermeture ligne d'alimentation 22 et simultanément ouverture ligne d'alimentation 23, puis arrêt du chauffage par rayonnement).

Pour ces conditions de traitement il est possible de former sur la surface interne de l'élément tubulaire en acier 32 CDV 13 un revêtement constitué par :

- Une sous-couche interne de diffusion d'azote-homogène ayant les caractéristiques suivantes : profondeur nitrurée minimale égale à 150 $\mu$m selon le critère microdureté Vickers Hv0,1 > [Hv0,1 (métal de base)+ 100]; microdureté Vickers superficielle maximale Hv 0,1 > 700.
- Une sous-couche externe compacte d'épaisseur uniforme égale à 10 um, formée de la phase $Cr_7C_3$ de structure hexagonale caractérisée par une microdureté Vickers superficielle voisine de 2000 Hv 0,1.

A titre comparatif et en vue de démontrer l'intérêt d'effectuer une première séquence de décapage ionique réactif (nitruration ionique) avant dépôt d'un revêtement de carbure de chrome des essais de rayure à l'aide d'un appareillage type REVETEST et des essais de fatigue thermique ont été respectivement réalisés sur un substrat en acier 32CDV13 revêtu de carbure de chrome $Cr_7C_3$ obtenu à l'état cristallisé et sur le même substrat 32CDV13 successivement nitruré par voie ionique et revêtu de carbure de chrome $Cr_7C_3$ obtenu à l'état cristallisé; dans les deux cas de figures l'épaisseur du revêtement de carbure de chrome étant voisine de 10 $\mu$m et le substrat étant à l'état trempé-revenu.

L'essai de rayure consiste à rayer la surface revêtue au moyen d'une pointe cônique en diamant de type Rockwell c, d'angle au sommet 120° et terminée par un rayon de courbure de 200 $\mu$m, sur laquelle est exercée une charge croissante, et à détecter l'émission acoustique produite par l'endommagement (fissuration, écaillage,...) du revêtement. L'appareillage utilisé, du type REVETEST, a été développé par le Laboratoire Suisse de Recherches Horlogères (L.S.R.M). Il permet d'effectuer les essais de rayure en mode automatique, c'est-à-dire qu'il permet d'augmenter de façon constante la charge appliquée sur l'indenteur en cours de rayage; la vitesse de déplacement de l'échantillon revêtu et celle de la variation de la charge appliquée étant fixées avant essai. Dans cet essai, le changement brusque de la forme de la trace laissée par la pointe de l'indenteur sur l'échantillon revêtu constitue un critère de rupture d'adhésion entre le revêtement et le substrat. L'apparition de ce régime critique peut alors être décrit de la façon suivante :

- sous l'action d'une charge extrêmement faible, la pointe ne marque que le dépôt et n'engendre aucune déformation importante du substrat. Dans ces conditions, la pointe laisse sur l'échantillon une marque rectiligne très fine et à bord régulier.
- si la charge d'appui est accrue progressivement, il y a déformaton plastique du substrat et apparition de contraintes de cisaillement à l'interface entre le revêtement et le substrat. La déformation progressive du revêtement peut entraîner la présence de fissures dans les zones en extension de ce dernier, c'est-a-dire à proximité de la zone sollicitée par l'indentation (bords de l'empreinte) . Il peut se passer selon la tenacité et l'adhérence du revêtement :
- soit un brusque élargissement de la trace (cédage du substrat)
- soit l'apparition de motifs périodiques le long de celle-ci (déformation plastique du substrat avec développement de fissures dans le revêtement qui peuvent se traduire par des microécaillages ou écaillages selon l'adhérence du revêtement au substrat).

Ces observations conduisent à définir des critères de comportement liés à l'adhérence du dépôt qui sont les suivants :

- charge de début de fissuration du revêtement en fond d'empreinte,
- charge conduisant à des microécaillages en bordure d'empreinte,

- charge conduisant à l'affaissement du substrat avec morcellement et incrustation du revêtement en fond d'empreinte.

Les résultats d'essais de rayure présentés dans le Tableau I mettent en évidence l'amélioration sensible obtenue au niveau des propriétés d'adhérence du revêtement de carbure de chrome : $Cr_7C_3$ formé par thermolyse de bis(cumène)chrome, lorsqu'il est réalisé sur un substrat préalablement nitruré par voie ionique, c'est-à-dire réalisé selon le traitement séquencé décrit dans la présente invention.

Tableau I

Essais de rayure comparés sur acier 32CDV13

revêtu de carbure de chrome $Cr_7C_3$

- - - - - - - - - - - - - - - - - - - - - - - - - - - - -

| Traitement de surface | Charge de début de fissuration du revêtement $Cr_7C_3$ en fond d'empreinte | Charge de début de microécaillage en bordure d'empreinte | Charge conduisant l'affaissement du substrat avec morcellement et incrustation du revêtement en fond d'empreinte |
|---|---|---|---|
| Nitruration ionique+revêtement $Cr_7C_3$ (épaisseur : 10 µm) | 30 N | | 50 N |
| Revêtement $Cr_7C_3$ seul (épaisseur : 10 µm) | ∼ 0 N | 20 N | 20 N |

**Revendications**

1. Procédé de dépôt d'un revêtement du type céramique à base de carbures, nitrures, ou carbonitrures d'éléments métalliques tels que Cr,V,Zr,W,Mo,Co,Mn,Ni,Hf,Ta,Ti,Nb et Fe dans lequel on dépose le revêtement du type céramique à basse température en phase vapeur à partir de précurseurs organo-métalliques sur un substrat métallique, caractérisé en ce qu'on réalise préalablement à ce dépôt en phase vapeur et sans mise en contact avec une atmosphère oxydante et/ou polluante ultérieure, un décapage ionique réactif en atmosphère réductrice.

2. Procédé selon la revendication 1, caractérisé en ce que le décapage ionique réactif est une nitruration ionique.

3. Procédé selon la revendication 2, caractérisé en ce que la nitruration ionique est réalisée sous un mélange N2, H2 dont la teneur en azote est inférieure à 25% en volume, à une température du substrat de 400 à 600°C, sous une pression inférieure ou égale à 1kPa et de préférence inférieure à 0,5 kPa pour atteindre une épaisseur de couche de diffusion d'azote de 20 à 500 µm selon la nature du substrat.

**4.** Procédé selon l'une quelconque des revendications précédentes, caractérisé en ce que l'on réalise le dépôt en phase vapeur sur le substrat préalablement chauffé à une température de 300 à 700°C en présence d'un flux de gaz vecteur généralement inerte tel que Ar, He, contenant au moins un précurseur organo-métallique sous une pression totale inférieure à 10 kPa et de préférence inférieure à 5 kPa.

**5.** Procédé selon l'une quelconque des revendications précédentes caractérisé en ce qu'on dépose un revêtement de carbures de chrome de formule $Cr_7C_3$ en phase vapeur à partir de bis arènes chrome éventuellement substitués.

**6.** Procédé selon la revendication 5, caractérisé en ce qu'on dépose un revêtement de carbure de chrome de formule $Cr_7C_3$ en phase vapeur à partir de dicumène chrome comme précurseur.

**7.** Procédé selon la revendication 5, caractérisé en ce qu'on dépose un revêtement de carbure de chrome de formule $Cr_7C_3$ en phase vapeur à partir de dibenzène chrome comme précurseur.

**8.** Procédé selon la revendication 5, caractérisé en ce qu'on dépose un revêtement de carbure de chrome de formule $Cr_7C_3$ en phase vapeur à partir de bis(cyclopentadiényl)chrome comme précurseur.

**9.** Procédé selon l'une quelconque des revendications 1 à 4, caractérisé en ce qu'on dépose un revêtement de nitrures ou de carbonitrures d'éléments métalliques choisis parmi Cr,V,Zr,W,Mo,Co,Mn,Ni,Hf,Ta, Ti,Nb et Fe en phase vapeur en utilisant un système de précurseur constitué simultanément
   - d'un précurseur organo-métallique dudit élément métallique choisi parmi les composés organométallique de type sandwich de formule générale
$$[Ar^1 M Ar^2_n]L_x L'_y$$
dans laquelle $Ar^1$ et $Ar^2$ identiques ou différents représentent un cycle aromatique en $C_5$-$C_8$ éventuellement substitué par 1 à 6 groupes alkyles en $C_1$-$C_4$ ou un groupe phényle, n représente 0 ou 1, M représente l'élément métallique tel que défini ci-dessus, L et L' représentent isolément un atome d'hydrogène ou d'halogène, un groupe CO, NCO, NCS, $CF_3$, R, RCN, $PR_3$, SR, SeR, R étant un groupe alkyle en $C$-$C_4$ ou phényle éventuellement substitué par 1 ou 2 groupes alkyles en $C_1$-$C_4$, pyridyne, tétrahydrofuranne, acétylacétonate, tétracyanoquinodiméthane ou L et L' représentent ensemble avec M un cycle $MS_4$ ou $MS_5$ et x + y représentent de 0 à 4.
   - d'un précurseur d'azote choisi parmi l'ammoniac et l'hydrazine.

**10.** Procédé selon la revendication 9, caractérisé en ce que la précurseur organo-métallique est choisi parmi les composés de type sandwich dans lesquels l'élément métallique central est lié à deux cycles aromatiques identiques en $C_5$-$C_8$, éventuellement substitués par un à six groupes alkyle en $C_1$-$C_4$ .

**11.** Procédé caractérisé en ce que l'élément métallique est le chrome et le précurseur organo-métallique est choisi parmi le di (benzène) chrome, les bis (arène) chrome substitués par un à six groupes alkyle en $C_1$-$C_4$ et le bis (cyclopentadiényl) chrome.

**12.** Elément tubulaire ou plan constitué d'un substrat métallique comportant au moins sur un de ses faces un revêtement du type céramique à base de carbures, nitrures ou carbonitrures d'éléments métalliques choisi parmi Cr,V,Zr,W,Mo,Co,Mn,Ni,Hf,Ta,Ti,Nb et Fe déposé en une épaisseur de 5 à 200 µm sur une couche de diffusion d'azote ayant une épaisseur de 20 à 500 µm, réalisés par un procédé tel que défini selon l'une quelconque des revendications précédentes.

**13.** Elément tubulaire ou plan selon la revendication 12, caractérisé en ce que le substrat méallique est un acier de construction pour usage mécanique, un acier inoxydable, un alliage de zirconium, un alliage de titane, un super alliage base nickel ou un super alliage base cobalt.

**Patentansprüche**

**1.** Verfahren zur Abscheidung eines Überzugs von keramischer Art auf der Grundlage von Carbiden, Nitriden oder Carbonitriden metallischer Elemente wie Cr, V, Zr, W, Mo, Co, Mn, Ni, Hf, Ta, Ti, Nb und Fe, in welchem man den Überzug von keramischer Art bei niedriger Temperatur in der Dampfphase, ausgehend von organometallischen Vorläuferverbindungen, auf einem metallischen Substrat abscheidet, dadurch gekennzeichnet, daß man vor dieser Abscheidung in der Dampfphase und ohne Inkontakttreten mit einer oxidierenden Atmosphäre und/oder weiterem Schadstoff ein ionisch-reaktives Beizen in reduzierender Atmosphäre durchführt.

2. Verfahren nach Anspruch 1, dadurch gekennzeichnet, daß das ionisch-reaktive Beizen eine ionische Nitridierung ist.

3. Verfahren nach Anspruch 2, dadurch gekennzeichnet, daß man die ionische Nitridierung in einer $N_2/H_2$-Mischung, deren Stickstoffgehalt weniger als 25 Vol.-% beträgt, bei einer Temperatur des Substrats von 400 bis 600 °C und unter einem Druck von weniger als oder gleich 1 kPa und vorzugsweise geringer als 0,5 kPa durchführt, um eine Schichtdicke für die Stickstoff-Diffusion von 20 bis 500 $\mu$m, gemäß der Eigenschaft des Substrats, zu erhalten.

4. Verfahren nach einem der vorhergehenden Ansprüche, dadurch gekennzeichnet, daß man die Abscheidung in der Dampfphase auf das Substrat, welches vorher auf eine Temperatur von 300 bis 700 °C in Gegenwart eines Gastroms eines im allgemeinen inerten Trägergases wie Ar, He erhitzt wurde, das wenigstens eine organo-metallische Vorläuferverbindung enthält, unter einem Gesamtdruck von kleiner 10 kPa und vorzugsweise kleiner als 5 kPa durchführt.

5. Verfahren nach einem der vorhergehenden Ansprüche, dadurch gekennzeichnet, daß man einen Überzug aus Chromcarbiden der Formel $Cr_7C_3$ in der Dampfphase, ausgehend von eventuell substituierten Chrombis-Arenen, abscheidet.

6. Verfahren nach Anspruch 5, dadurch gekennzeichnet, daß man einen Überzug aus Chromcarbid der Formel $Cr_7C_3$ in der Dampfphase, ausgehend von Dicumol-Chrom als Vorläuferverbindung, abscheidet.

7. Verfahren nach Anspruch 5, dadurch gekennzeichnet, daß man einen Überzug aus Chromcarbid der Formel $Cr_7C_3$ in der Dampfphase, ausgehend von Dibenzol-Chrom als Vorläuferverbindung, abscheidet.

8. Verfahren nach Anspruch 5, dadurch gekennzeichnet, daß man einen Überzug aus Chromcarbid der Formel $Cr_7C_3$ in der Dampfphase, ausgehend von Bis(cyclopentadienyl)-Chrom als Vorläuferverbindung, abscheidet.

9. Verfahren nach einem der vorhergehenden Ansprüche 1-4, dadurch gekennzeichnet, daß man einen Überzug aus Nitriden oder Carbonitriden metallischer Elemente, ausgewählt aus Cr, V, Zr, W, Mo, Co, Mn, Ni, Hf, Ta, Ti, Nb und Fe, in der Dampfphase unter Verwendung eines Vorläufersystems abscheidet, das gleichzeitig besteht aus:
   - einer organometallischen Vorläuferverbindung des genannten metallischen Elements, ausgewählt aus den organometallischen Verbindungen vom Sandwich-Typ der allgemeinen Formel:
   $$[Ar^1\ M\ Ar^2_n]L_x\ L'_y,$$
   in der $Ar^1$ und $Ar^2$, gleich oder verschieden, einen gegebenenfalls durch 1 bis 6 $C_1$-$C_4$-Alkylgruppen substituierten cylischen Aromaten von $C_5$ bis $C_8$ oder eine Phenylgruppe darstellen, n 0 oder 1 ist, M ein metallisches Element wie nachstehend definiert ist, L und L' getrennt voneinander ein Wasserstoffatom oder Halogen, eine CO-, NCO-, NCS-, $CF_3$-, R-, RCN-, $PR_3$-, SR-, SeR-Gruppe darstellen, R eine Alkylgruppe aus $C_1$-$C_4$ oder eine eventuell durch 1 oder 2 mit $C_1$-$C_4$-Alkylgruppen substituierte Phenylgruppe, Pyridin, Tetrahydrofuran, Acetylacetonat, Tetracyanochinondimethan ist oder L und L' zusammen mit M einen $MS_4$- oder $MS_5$-Zyklus darstellen und x + y 0 bis 4 ist,
   - einer Stickstoff-Vorläuferverbindung, ausgewählt aus Ammoniak und Hydrazin.

10. Verfahren nach Anspruch 9, dadurch gekennzeichnet, daß die organometallische Vorläuferverbindung aus Verbindungen vom Sandwich-Typ ausgewählt ist, in denen das metallische Zentralatom an zwei, in $C_5$-$C_8$ gleiche, gegebenenfalls durch eine bis sechs $C_1$-$C_4$-Alkylgruppen substituierte, aromatische Ringe gebunden ist.

11. Verfahren, dadurch gekennzeichnet, daß das metallische Element Chrom ist und daß die organometallische Vorläuferverbindung ausgewählt ist aus Dibenzol-Chrom, den durch eine bis sechs $C_1$-$C_4$ -Alkylgruppen substituierten Chrom-bis-Arenen und Bis-(cyclopentadienyl)-Chrom.

12. Rohrförmiges oder ebenes Teil, bestehend aus einem metallischen Substrat, das wenigstens auf einem seiner Seiten einen Überzug keramischer Art auf der Grundlage von Carbiden, Nitriden oder Carbonitriden metallischer Elemente, ausgewählt aus Cr, V, Zr, W, Mo, Co, Mn, Ni, Hf, Ta, Ti, Nb und Fe, enthält, der in einer Dicke von 5 bis 200 μm auf eine Stickstoff-Diffusionsschicht einer Dicke von 20 bis 500 μm aufgetragen ist und der nach einem Verfahren gemäß einem der vorhergehenden Ansprüche hergestellt worden ist.

13. Rohrförmiges oder ebenes Teil gemäß Anspruch 12, dadurch gekennzeichnet, daß das metallische Substrat ein Konstruktionsstahl für mechanische Anwendung, ein rostfreier Stahl, eine Zirkonlegierung, eine Titanlegierung, eine Superlegierung auf Nickelbasis oder eine Superlegierung auf Cobaltbasis darstellt.

## Claims

1. Process for depositing a coating of the ceramic type based on carbides, nitrides or carbonitrides of metallic elements such as Cr, V, Zr, W, Mo, Co, Mn, Ni, Hf, Ta, Ti, Nb and Fe, in which the coating of the ceramic type is deposited at low temperature in vapour phase starting with organometallic precursors on a metallic substrate, characterized in that a reactive ionic cleaning is carried out in a reducing atmosphere before this deposition in vapour phase and without subsequent bringing into contact with an oxidizing and/or contaminating atmosphere.

2. Process according to Claim 1, characterized in that the reactive ionic cleaning is an ionic nitriding.

3. Process according to Claim 2, characterized in that the ionic nitriding is carried out under an $N_2$, $H_2$ mixture whose nitrogen content is lower than 25 % by volume, at a substrate temperature of 400 to 600°C, at a pressure lower than or equal to 1 kPa and preferably lower than 0.5 kPa to reach a thickness of the nitrogen diffusion layer of 20 to 500 μm, depending on the nature of the substrate.

4. Process according to any one of the preceding claims, characterized in that the deposition in vapour phase is carried out on the substrate preheated to a temperature of 300 to 700 °C in the presence of a flow of generally inert carrier gas such as Ar or He, containing at least one organometallicprecursor at a total pressure lower than 10 kPa and preferably lower than 5 kPa.

5. Process according to any one of the preceding claims, characterized in that a coating of chromium carbides of the formula $Cr_7C_3$ is deposited in vapour phase by starting with optionally substituted chromium bisarenes.

6. Process according to Claim 5, characterized in that a chromium carbide coating of formula $Cr_7C_3$ is deposited in vapour phase by starting with dicumenechromium as precursor.

7. Process according to Claim 5, characterized in that a chromium carbide coating of formula $Cr_7C_3$ is deposited in vapour phase by starting dibenzenechromium as precursor.

8. Process according to Claim 5, characterized in that a coating of chromium carbide of formula $Cr_7C_3$ is deposited in vapour phase by starting with bis(cyclopentadienyl)chromium as precursor.

9. Process according to any one of Claims 1 to 4, characterized in that a coating of nitrides or of carbonitrides of metallic elements chosen from Cr, V, Zr, W, Mo, Co, Mo, Co, Mn, Ni, Hf, Ta, Ti, Nb and Fe is deposited in vapour phase by employing a precursor system consisting simultaneously
   - of an organometallic precursor of the said metallic element, chosen from organometallic compounds of the sandwich type of general formula
     $$[Ar^1MAr^2_n]L_xL'_y$$
     in which $Ar^1$ and $Ar^2$, which are identical or different, denote a $C_5$-$C_8$ aromatic ring optionally substituted by 1 to 6 $C_1$-$C_4$ alkyl groups or a phenyl group, n denotes 0 or 1, M denotes the metallic element as defined above, L and L' denote, in isolation, a hydrogen or halogen atom or a CO, NCO, NCS, $CF_3$, R, RCN, $PR_3$, SR, SeR, R being a $C_1$-$C_4$ alkyl or phenyl group optionally substituted by one or two $C_1$-$C_4$ alkyl groups, pyridine, tetrahydrofuran, acetylacetonate or tetracyanoquinodimethane group or L and L' together with M denote an $MS_4$ or $MS_5$ ring and x + y denote from 0 to 4,
   - of a nitrogen precursor chosen from ammonia and hydrazine.

10. Process according to Claim 9, characterized in that the organometallic precursor is chosen from compounds of the sandwich type in which the central metallic element is bonded to two identical $C_5$-$C_8$ aromatic rings which are optionally substituted by one to six $C_1$-$C_4$ alkyl groups.

11. Process characterized in that the metallic element is chromium and the organometallic precursor is chosen from di(benzene)chromium, bis(arene)chromiums substituted by one to six $C_1$-$C_4$ alkyl groups and bis(cyclopentadienyl)chromium

12. Tubular or planar element consisting of a metallic substrate comprising at least on one of its faces a coating of the ceramic type based on carbides, nitrides or carbonitrides of metallic elements, chosen from Cr, V Zr, W, Mo, Co, Mn, Ni, Hf, Ta, Ti, Nb and Fe and deposited in a thickness of 5 to 200 $\mu$m on a nitrogen diffusion layer which has a thickness of 20 to 500 $\mu$m, which are produced by a process as defined according to any one of the preceding claims.

13. Tubular or planar element according to Claim 12, characterized in that the metallic substrate is a structural steel for mechanical use, a stainless steel, a zirconium alloy, a titanium alloy, a nickel based superalloy or a cobalt based superalloy.

FIG.1

FIG.2